# EUROPEAN PATENT APPLICATION

(11) **EP 2 017 687 A1**
(43) Date of publication of application: **21.01.2009**
(21) Application number: 08012406.8
(22) Date of filing: 09.07.2008
(51) Int. Cl.: G05D 23/19, H05K 7/20

(54) **System and method for environmental control of an enclosure**

(30) Priority: 16.07.2007 US 778113
(71) Applicant: Motorola, Inc., Schaumburg, IL 60196 (US)
(72) Inventor: Gutierrez, Greg M., Hampshire Illinois 60140 (US); Frendreiss, David M., Algonquin Illinois 60102 (US); Gibson, Christopher J., Madison Wisconsin 53726 (US); Larsen, Kevin J., South Elgin Illinois 60177 (US); Nestor, Marc N., Lombard Illinois 60148 (US); Turocy, James W., Arlington Heights Illinois 60004 (US); Warych, Dan B., Lake Zurich Illinois 60047 (US); Berriman, Robert A., Elk Grove Village Illinois 60007 (US)
(74) Representative: Openshaw, Paul Malcolm

(57) **Abstract**

Unheated external air is drawn into an electronic component housing (200). The external air is selectively heated to form heated air (209) and the extent of the heating is based at least in part upon the temperature within the electronic component housing (200). The heated air (209) or the unheated external air (206) is drawn across at least one electronic component (210) positioned within the electronic component housing (200). A first flow (222) of either the heated air or the unheated external air is selectively exhausted from the electronic component housing (200). A first amount of the first flow (222) is based at least in part upon the temperature within the electronic component housing. A second flow (216) of either the heated air or the unheated external air is selectively re-circulated within the housing. A second amount of the second flow (216) is based at least in part upon the temperature within the housing (200). The influx, heating, exhausting, and re-circulating operate so as to cause the temperature within the housing (200) to stay within a predetermined range.

## Description

### Related Applications

This application is related to a co-pending application entitled "APPARATUS AND METHOD FOR AIR CIRCULATION," filed on even date herewith, assigned to the assignee of the present application, and hereby incorporated by reference.

### Field of the Invention

The field of the invention relates generally to environmental enclosures and more particularly to managing the environmental conditions within enclosures

### Background of the Invention

Enclosures are used to retain different types of electronic components and protect these components from extreme environmental conditions or hazards. For example, in cellular communication systems, base station components are typically housed in enclosures to protect the components from extreme heat or cold. In this case, the components may include circuit boards that perform the various functions of the base stations. Other components may also be used within the enclosures. For example, heaters may be used to heat the electronic components when the temperature of the enclosure drops below a threshold. Additionally, the enclosures also may include fans to cool the electronic components as the components within the enclosure generate heat.

Maintaining satisfactory operating conditions within enclosures has been difficult to achieve in previous systems. For instance, it is frequently difficult to maintain the proper temperature within enclosures using conventional heating and cooling components and still efficiently operate the system. In one example of these problems, if a heater within the enclosure is activated for long periods of time, the components within the enclosure may overheat. In another example, operating the fans more often than needed may waste substantial amounts of energy and lead to increased operating costs for the system.

Prior systems have sometimes used microprocessors or other types of programmable controllers to operate the heating and cooling components of the system. Specifically, microprocessors were used to activate and deactivate the fans and heaters in the system based upon factors such as the measured temperature within the enclosure. However, because of the costs associated with programming the microprocessors, these microprocessor-based systems were expensive to design and build. Additionally, when operational, these systems were often difficult to maintain. For example, the microprocessors used in these previous systems were themselves often vulnerable to extreme environmental conditions.

Other previous systems omitted the use of microprocessors for controlling the heating and cooling components of the system. However, these systems typically could not maintain a constant or nearly constant temperature within the enclosure under at least some operating conditions. Consequently, these previous systems proved inadequate in preventing temperature swings within the enclosure and/or preventing the occurrence of over-temperature or under-temperature conditions within the enclosure.

### Brief Description of the Drawings

The above needs are at least partially met through provision of a method and apparatus for environmental control of an enclosure described in the following detailed description, particularly when studied in conjunction with the drawings, wherein:

FIG. 1 comprises an electrical diagram of a system for controlling the environmental conditions within an enclosure in accordance with various embodiments of the invention;

FIG. 2 comprises a diagram of a system for controlling the environmental conditions within an enclosure according to various embodiments of the invention;

FIG. 3 comprises a diagram of a damper arrangement according to various embodiments of the invention;

FIG. 4 comprises a side view of the damper arrangement of FIG. 3 according to various embodiments of the invention;

FIG. 5 is flowchart of an approach for regulating environmental conditions within an enclosure according to various embodiments of the invention;

FIG. 6 comprises a state diagram showing various states of a system for regulating environmental conditions of an enclosure according to various embodiments of the invention;

FIG. 7 is an exploded perspective view of an air circulation module according to various embodiments of the present invention;

FIG. 8 is a perspective view of a re-circulation valve and spring according to various embodiments of the present invention;

FIG. 9 is a cutaway perspective view showing the re-circulation valve of the air circulation module open according to various embodiments of the present invention; and

FIG. 10 is a cutaway perspective view showing the re-circulation valve of the air circulation module closed according to various embodiments of the present invention.

Skilled artisans will appreciate that elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present invention. Also, common but well-understood elements that are useful or necessary in a commercially feasible embodiment are often not depicted in order to facilitate a less obstructed view of these various embodiments of the present invention. It will further be appreciated that certain actions and/or steps may be described or depicted in a particular order of occurrence while those skilled in the art will understand that such specificity with respect to sequence is not actually required. It will also be understood that the terms and expressions used herein have the ordinary meaning as is accorded to such terms and expressions with respect to their corresponding respective areas of inquiry and study except where specific meanings have otherwise been set forth herein.

### Detailed Description of Embodiments

A system and method are provided that maintain satisfactory environmental conditions within enclosures without the use of microprocessors and by using only passive, non-microprocessor-based electrical or electronic components. The approaches described herein are easy to use and result in the ability to accurately and efficiently regulate and maintain environmental conditions within enclosures.

In many of these embodiments, unheated external air is selectively drawn into an electronic component housing. The external air that is drawn into the electronic component housing is selectively heated to form heated air and the extent of the heating is based at least in part upon the temperature within the electronic component housing. Either the heated air or the unheated external air is drawn across at least one electronic component positioned within the electronic component housing. A first flow of the heated air or the unheated external air that has been drawn across the electronic component is selectively exhausted from the electronic component housing. The amount of the first flow is based at least in part upon the temperature within the electronic component housing. A second flow of the heated air and the unheated external air that has been drawn across the electronic component is selectively re-circulated within the electronic component housing. The amount of the second flow is based at least in part upon the temperature within the housing. The influx, heating, exhausting, and re-circulating operate so as to cause the temperature within the electronic component housing to stay within a predetermined range.

In others of these embodiments, a system (e.g., an enclosure for housing base station components) includes a housing and an entrance portal that extends through the housing. At least one heater is positioned within the housing and is in communication with the entrance portal. The heater is adapted to selectively heat external air flowing through the entrance portal to form heated air. The amount of heating may be based upon various factors such as the temperature within the housing. The system also includes an air flow control device and at least one electronic component that is positioned between the at least one heater and the air flow control device. The air flow control device is adapted to draw the heated air across the electronic component and selectively direct the flow of the air that has been drawn across the electronic component into at least one of a plurality of pathways based upon the temperature within the housing. The amount of the flow into each of the plurality of passageways is chosen and the activation of the at least one heater is made so as to cause the temperature within the housing to stay within a predetermined range.

Thus, approaches are provided that control the environmental conditions within an enclosure. The approaches described herein are easy and cost effective to implement and prevent the occurrence of environmental conditions within the enclosure that might disable or otherwise damage the components housed within the enclosure.

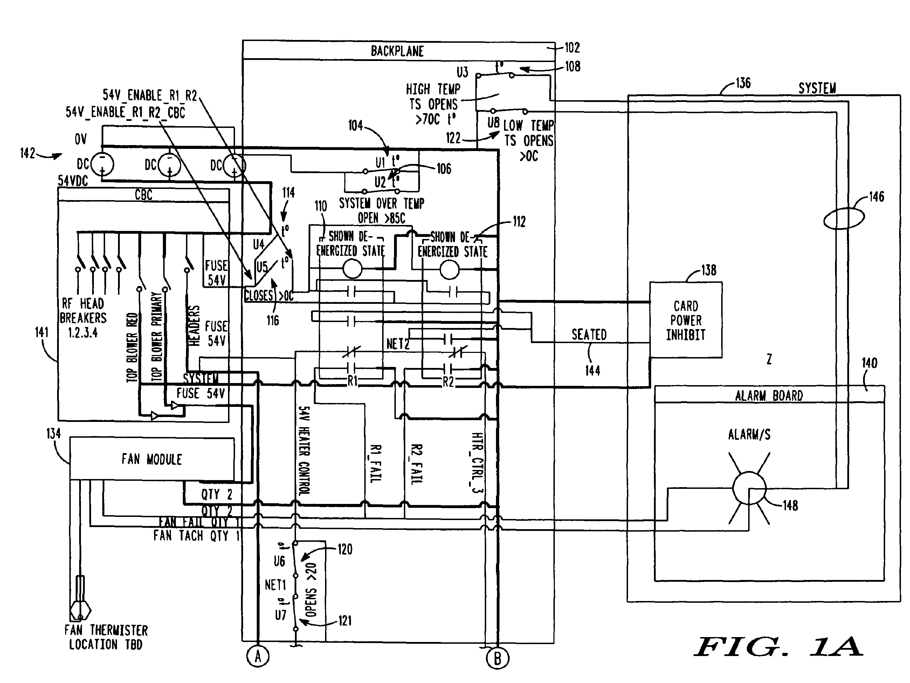

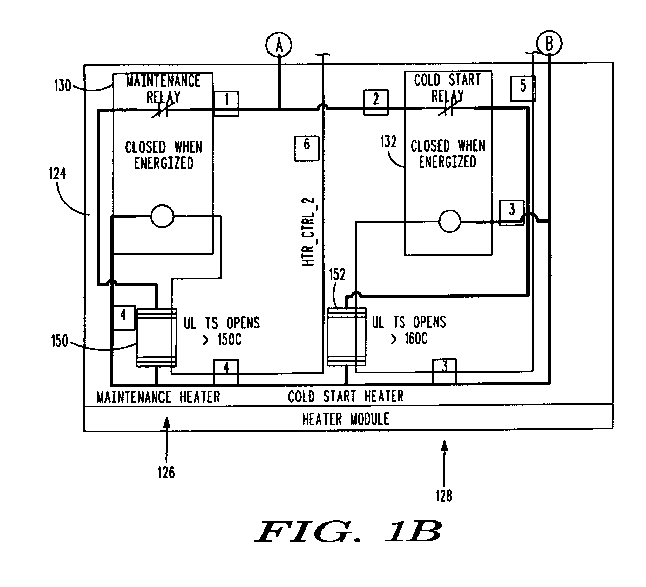

Referring now to FIG. 1, an example of a system for controlling the environmental conditions of an enclosure is described. In particular, in the examples described herein, the temperature within a cellular base station enclosure is regulated. However, it will be appreciated that any other type of environmental condition can be regulated. Additionally, although the enclosures described herein are described as including base station components for a cellular communication system, it will be understood that the enclosures may house any type of electrical and/or mechanical components. Furthermore, it will be understood that the temperatures or temperature ranges described herein are approximate and can also be varied according to the needs of the user or the system. Additionally, the temperatures and temperature ranges recited herein are examples only and can be varied according to the needs of the user or the system.

A backplane 102 includes a first thermostat 104, a second thermostat 106, and a third thermostat 108. The first thermostat 104 and the second thermostat 106 are over-temperature devices that are open at temperatures of greater than 85 degrees Celsius and are closed otherwise. The third thermostat 108 is a high-temperature device and is open at temperatures of 70 degrees Celsius or greater and is closed otherwise.

The backplane 102 also includes a first switch 110, a second switch 112, a fourth thermostat 114, and a fifth thermostat 116. The fourth thermostat 114 and the fifth thermostat 116 are closed at temperatures of above 0 degrees Celsius and are open otherwise. The backplane 102 also includes a sixth thermostat 120 and seventh thermostat 121 that are open at temperatures above 20 degrees Celsius and are closed otherwise. The backplane 102 additionally includes an eighth thermostat 122 that opens at temperatures of less than 0 degrees Celsius and is closed otherwise.

The backplane 102 is connected to a heater module 124. The heater module 124 includes a first heater 126 and a second heater 128. The first heater 126 is controlled by a third relay 130 and the second heater 128 is controlled by a fourth relay 132. The purpose of the third relay 130 and the fourth relay 132 are to act as safety disconnect devices if any of the heaters enter a run away condition and/or the thermostat 108 malfunctions or has a significant time lag. The third relay 130 and fourth relay 132 are connected to a ninth thermostat 150 and tenth thermostat 152 respectively (controlling the first heater 126 and the second heater 128). The ninth thermostat 150 and tenth thermostat 152 activate at approximately 150 degrees Celsius.

A fan module 134 is coupled to the backplane 102 and to system components 136. The fan module 134 may include one or more air circulation elements (e.g., fans). The system components 136 include one or more electrical components that perform or implement the functions of an electronic system. For example, these components may implement base station functions for a cellular communication system. The system components 136 include a card power inhibit circuit 138 and an alarm board 140. Power supplies 142 supply power to the various components of the system. A Circuit Breaker Card (CBC) 141 includes fuses and/or breakers that are coupled to the backplane 102, the fan module 134, and the heater module 124. Power is provided to but not necessarily utilized by the system when a user activates the circuit breakers on the CBC 141 and the power supplies 142.

The system of FIG.1 may also utilize a re-circulation valve (not shown in FIG. 1) to selectively re-circulate air within the enclosure. Additionally, the system of FIG. 1 may use a moveable damper (not shown in FIG. 1) to selectively exhaust air from the enclosure.

In one example of the operation of the system of FIG. 1, a cold start may occur (at temperatures of below 0 degrees Celsius to 0 degrees Celsius) when a user throws the main breaker, turns on the power supplies, and/or engages the sub-system level circuit breakers on the CBC 141. In this situation, the fourth thermostat 114 and fifth thermostat 116 are open, which de-activates the first switch 110 and the second switch 112. In addition, when the first switch 110 and the second switch 112 are de-activated, power is provided to and utilized by the second heater 128. When the first switch 110 and the second switch 112 are de-activated, power is inhibited to the system components 136. Independent of the first switch 110 and second switch 112, the sixth thermostat 120 and seventh thermostat 121 are closed, in one example, based upon temperature alone (e.g., when the temperature within the enclosure is less than 20 degrees Celsius).

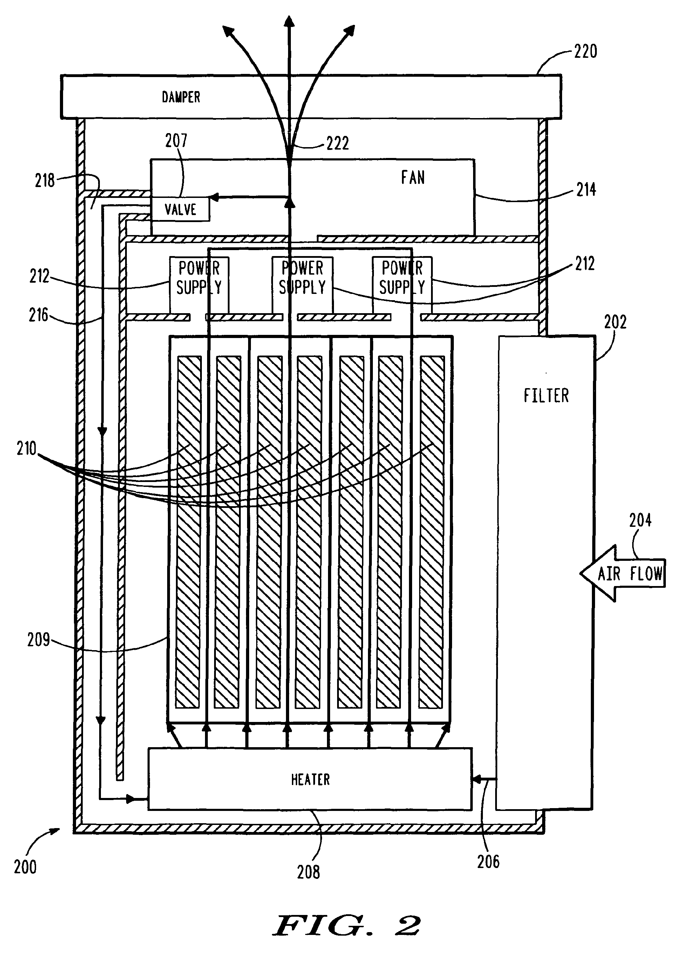

When the sixth thermostat 120 and seventh thermostat 121 are closed, power is provided to and utilized by the first heater 126. At a temperature of -10 degrees Celsius, one or more of the fans in the fan module 134 starts up and runs, in one example, at 750 rpm. Air is moved through a re-circulation valve (e.g., the re-circulation valve 207 shown in FIG. 2), through a re-circulation path (e.g., the re-circulation path 218 shown in FIG. 2), back across the heaters 126 and 128, and through the system components 136. As the air is further re-circulated and passed over the first heater 126, second heater 128, and system components 136, its temperature rises.

Once the temperature of the air reaches 0 degrees Celsius, the fourth thermostat 114 and the fifth thermostat 116 close. When the fourth thermostat 114 and the fifth thermostat 116 close, the first switch 110 and second switch 112 are energized. When the first switch 110 and second switch 112 are energized, the system inhibit line 144 is de-activated and the system utilizes the power provided to it by the CBC 141. Additionally, when the first switch 110 and second switch 112 are energized, the second heater 128 is de-activated.

In another example, if the system were to drop below 0 degrees Celsius (e.g., a maintenance person leaves the front door open or ajar and the door alarm is defeated or malfunctions), the second heater 128 is not re-energized. Once the first switch 110 and second switch 112 are energized, the system inhibit line is deactivated, and the system is in a run state and will not re-start the second heater 128. In one example, all heating functions are dealt with by the first heater 126 and the system components 136 within the enclosure. The second heater 128 will only re-start if power is lost to the system and it experiences a new, cold start event thereby re-setting the first switch 110 and second switch 112 to a de-energized state.

When a high-temperature condition occurs (e.g., the temperature exceeds a predetermined threshold), the third thermostat 108 opens. The occurrence of this condition causes an alarm to be sent to the alarm board 140 on alarm lines 146. An alarm indictor 148 (e.g., light emitting diode (LED)), may be activated to visually inform the user of the alarm condition. When an over-temperature condition occurs, the first thermostat 104, second thermostat 106 are opened. The power input to the backplane 102 from the power supplies 142 is deactivated. The second heater 128, the first heater 126, the system components 136, and the fan module 134 then turn off. The occurrence of these conditions causes an alarm to be sent to the alarm board 140 on alarm lines 146

When an under-temperature condition occurs (e.g., the temperature falls below a predetermined threshold), the eighth thermostat 122 opens when the temperature within the enclosure falls below a threshold (e.g., the temperature within the enclosure is less than 0 degrees). This occurrence sends an alarm signal 146 to the alarm board. An alarm indictor 148 (e.g., light emitting diode (LED)), may be activated to visually inform the user of the alarm condition.

In another example of the operation of the system of FIG. 1, the system may operate in a transitional operation or cold maintenance operation (e.g., at temperature ranges of 0 to 20 degrees Celsius). In a transition from a cold start event, as the air is further heated the temperature rises, the re-circulation valve begins to close, the damper begins to open, a small quantity of air is drawn in through the filter, and the rate of internal temperature rise is slowed. When and if the internal air temperature reaches 20 degrees Celsius the first heater 126 turns off and system heating is handled by the system components 136.

If the temperature of the air never reaches 20 degrees Celsius, the first heater 126 remains energized. If the temperature of the air rises above 20 degrees Celsius, the first heater turns off, if over time the temperature falls again to below 20 Celsius, the first heater 126 turns back on to provide energy to the re-circulated and incoming air streams. The first heater 126 will continue to cycle with hysterisis. During this transitional state, re-circulation valve, exhaust damper, and fan module 134 are in various states of operation all combining to maintain the optimal temperature within the enclosure while minimizing hysterisis.

In another example of the operation of the system of FIG. 1, the system starts at ambient temperatures between 0 degrees Celsius and 20 degrees Celsius. In this case, the system may experience a power up condition when a user throws the main breaker, turns on the power supplies, and/or engages the sub-system level circuit breakers on the CBC (Circuit Breaker Card). Power is provided to and utilized by the system when a user activates the circuit breakers and power supplies. The fourth thermostat 114 and fifth thermostat 116 are closed, which activates the first switch 110 and the second switch 112. When the first switch 110 and second switch 112 are activated, power is not provided to the second heater 128. Additionally, when the first switch 110 and second switch 112 are activated, power is not inhibited to the system 138. Independent of the operation of the first switch 110 and second switch 112, the sixth thermostat 120 and seventh thermostat 121 are closed, in one example, based on temperature alone (e.g., temperatures of less than 20 degrees Celsius).

When the sixth thermostat 120 and seventh thermostat 121 are closed, power is provided to and utilized by the first heater 126. At a temperature of 0 degrees Celsius, one or more of the circulation elements of the fan module 134 start up and runs, for example, at 750 rpm. The speed is variable and depends upon the air temperature, for instance, speeding up to an rpm of 1090 rpm at an air temperature of 20 degrees Celsius. Air is moved through a re-circulation valve (e.g., valve 207, discussed in connection with FIG. 2 below), through a re-circulation path (e.g., re-circulation path 218, discussed in connection with FIG. 2 below), back across the first heater 126 and second heater 128 and through the electronics (e.g., electronics 210 discussed in connection with FIG. 2 below). The re-circulation valve position is also variable and reacts according to air temperature so as to reduce and finally close the flow stream through the re-circulation path at 50 degrees Celsius. At 10-12 degrees Celsius, the exhaust damper will start to break seal and a small inflow of cold ambient air will be pulled in through the filter. As the fan speed rises this effect increases. As the air is further re-circulated, exhausted, and introduced through the filter and passed over the first heater 126, second heater 128, and system components 134 its temperature changes until it reaches an equilibrium point determined by all of the afore mentioned system effects as well as ambient air temperature, system power load, external wind speed, sunlight, and other ambient effects.

In still another example of the operation of the system of FIG. 1, at temperatures above 20 degrees Celsius, both the first heater 126 and second heater 128 are off. Start up would proceed as described above, but without the first heater 126 or second heater 128 being activated. At temperatures from 20 degrees Celsius up to approximately 50 degrees Celsius, the re-circulation valve is still open to some extent and would allow a decreasingly small amount of flow through the re-circulation path eventually diminishing to zero flow. The fan speed increases in response to higher temperatures caused by increased system load, environmental conditions, or other factors thereby causing the exhaust damper to rise thereby increasing the amount of exhaust flow out of the enclosure.

Referring now to FIG. 2, one example of an enclosure 200 and approaches for maintaining environmental conditions within the enclosure 200 are described. The enclosure 200 includes a filter 202 that accepts an air flow 204. The filter 202 removes particulate matter from the air (e.g., smoke, dust, dirt) and water in the liquid phase before the matter or liquid water enters the enclosure 200. The filter 202 outputs a filtered air flow 206, which is received by a heater 208. The heater 208 selectively heats the filtered air flow 206 and creates a heated air flow 209, which moves over, across, and around circuit boards 210. In this example, the circuit boards 210 are the electronic functional components of a cellular base station communication system. Depending upon the temperature (or other conditions) within the enclosure, the heater 208 may be activated to heat the filtered air flow 206. Alternatively, the heater may be deactivated and the filtered air flow 206 may be drawn (unheated) over, across, and around the circuit boards 210 in order to cool these components.

The heated air flow 209 (or the unheated filtered air flow) is drawn past power supplies 212 and through a fan 214. The fan 214 is coupled to and/or includes a re-circulation valve 207 that selectively allows a return air flow 216 to pass into a conduit 218 and return to the heater 208. In one example, the re-circulation valve 207 includes a bi-metallic spring or coil that expands and contracts to alternatively allow the air to flow through the conduit 216 (back to the heater 208) or prevent the air flow from entering the conduit 216. In one example, the air flow is re-circulated back to the heater 208 at temperatures of between -40 degrees Celsius and 50 degrees Celsius.

The damper 220 is arranged and constructed to alternatively rise and fall to allow an exhaust air flow 222 to be exhausted from the enclosure 200. The damper may be a plastic or other suitable material configured as a plate-like lid that rises or falls into position depending upon the air pressure inside the enclosure 200. The air pressure inside the enclosure 200 may depend upon the temperature, the amount of air being re-circulated, and the amount of air being drawn into the enclosure 200 through the air filter 202. Other factors may also determine or influence the pressure within the enclosure 200. In one example, the air flow 222 may be exhausted from the enclosure 200 at temperatures of 12 degrees Celsius or greater. In another example, the air flow 222 may be exhausted from the enclosure at temperatures of 10-12 degrees Celsius or greater.

The approaches described herein incorporate passive elements to maintain substantially constant environmental conditions (e.g., a substantially constant temperature) within enclosures. By selectively activating and deactivating the components (e.g., the heater 208, fan 214, and re-circulation valve 207), a substantially constant temperature may be achieved and maintained. If the temperature is above a threshold value (e.g., the damper 220 is open, the fan 214 is turning at a predetermined speed) air is drawn into the enclosure and the air is selectively heated. For example, the heater 208 may be activated at a cold start and the heater 208 may be deactivated when a predetermined temperature (e.g., 20 degrees Celsius) is reached. Additionally, the heater 208 may be reactivated when the temperature within the enclosure falls below a predetermined threshold.

The example of FIG. 2 shows one possible component layout and the selection of components that can be used to achieve a predetermined environmental goal (e.g., the maintenance a predetermined temperature range within the enclosure). It will be appreciated that other example layouts for the enclosure 200 and other component selections are possible. Additionally, it will be understood that the dimensions of the structure including the relative sizing of the components (e.g., the diameter or shape of the damper 220, or size of the conduit 218) may be adjusted according to the needs and requirements of the system or user. Further, it will be appreciated that the types of components chosen may change and the operation of these components may also be varied according to the goals of the system. For example, the temperature ranges indicated above may be varied by the use of additional heaters or fans. In another example, the placement of the electronic components 210 may be varied relative to the other components. In still another example, some of the components (e.g., the filter 202) may be removed.

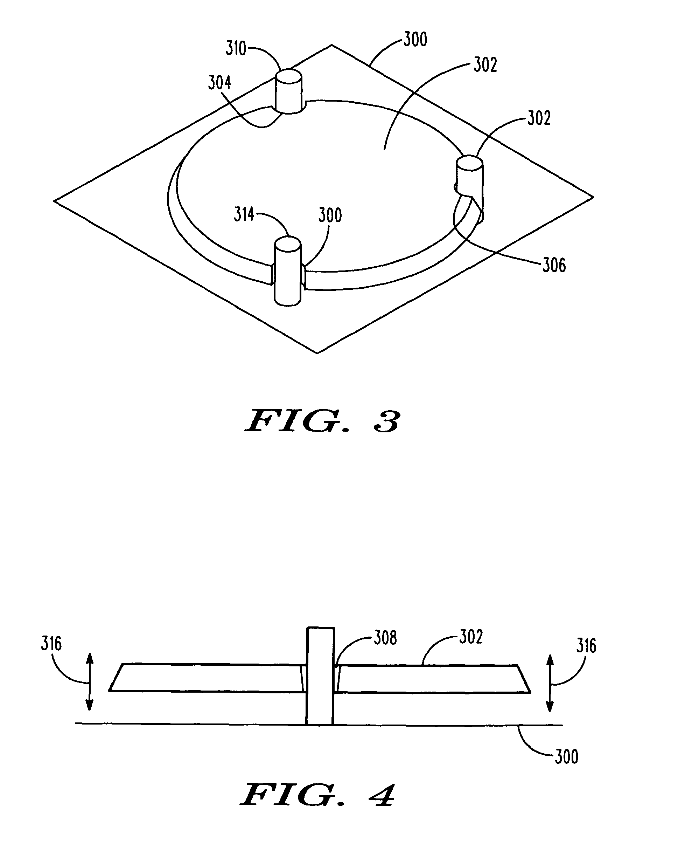

Referring now to both FIG. 3 and FIG. 4, one example of a damper structure at the top of an enclosure 300 is described. The damper structure includes a lid 302. The lid includes grooves 304, 306, and 308. The grooves 304, 306, and 308 communicate with rods 310, 312, and 314. As the pressure inside the enclosure changes, the lid 302 rises and falls in the directions indicated by the arrows 316.

The amount of pressure in the enclosure 300 affects the amount of lift of the lid 302. For example, a relatively high amount of pressure causes the lid 302 to rise to its greatest height (i.e., to its fully open position) and, consequently, release the greatest amount of air from the enclosure 300. In contrast, when the pressure inside the enclosure 300 is relatively low, the lid 302 falls to its lowest point (i.e., to its closed position) and substantially no air flows out through the damper. In middle pressure ranges, the lid 302 may be raised by the pressure within the enclosure to a middle position and a medium amount of air exhausts from the enclosure.

The amount of pressure inside the enclosure 300 may depend upon various factors. For example, the amount of pressure may depend directly or indirectly upon the temperature of the enclosure 300, whether the fan is running, the number of heaters running, the amount of electronics in the enclosure 300, and the amount of air re-circulation provided by the system (e.g., by a re-circulation valve). The weight, structure, and material used in the enclosure 300 and/or the lid 302 of the enclosure 300 may also affect the pressure as may environmental conditions outside of the enclosure 300. Other factors or conditions may also influence the pressure within the enclosure 300.

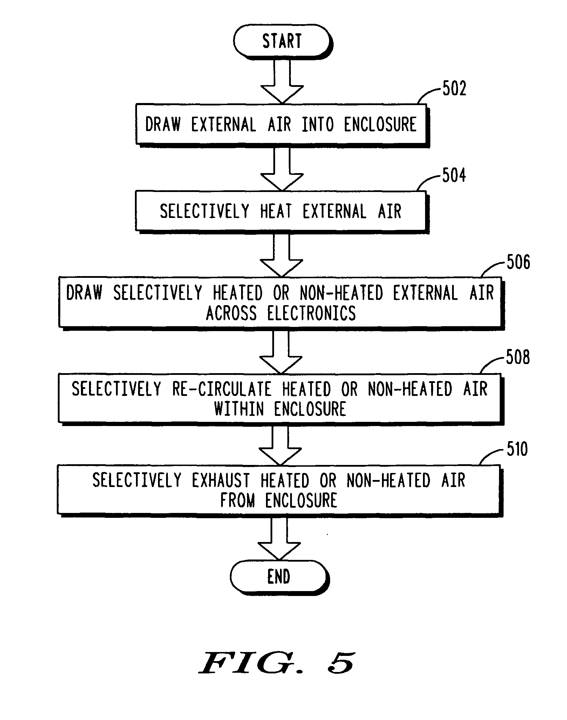

Referring now to FIG. 5, one example of an approach for maintaining optimum environmental conditions within an enclosure is described. At step 502, external air is selectively drawn into the enclosure, which in one example is an electronic component housing. At step 504, the external air that is drawn into the enclosure is selectively heated to form heated air. The extent of the heating is based at least in part upon the temperature within the electronic component housing. For example, no heating may be needed at some temperatures while a maximum amount of heating may be used at other temperatures.

At step 506, the heated air is selectively drawn across at least one electronic component positioned within the electronic component housing. Unheated air may also be drawn under selected circumstances. At step 508, a first flow of the heated air (or unheated air, when the heater is deactivated) that has been drawn across the at least one electronic component is selectively re-circulated. The amount of the first flow is based at least in part upon the temperature within the housing.

At step 510, a second flow of the heated air (or unheated air, when the heater is deactivated) that has been drawn across the at least one electronic component is selectively exhausted from the electronic component housing. The amount of the second flow is based at least in part upon the temperature within the electronic component housing. The heating, exhausting, and re-circulating operate so as to cause the temperature within the electronic component housing to stay within a predetermined temperature range.

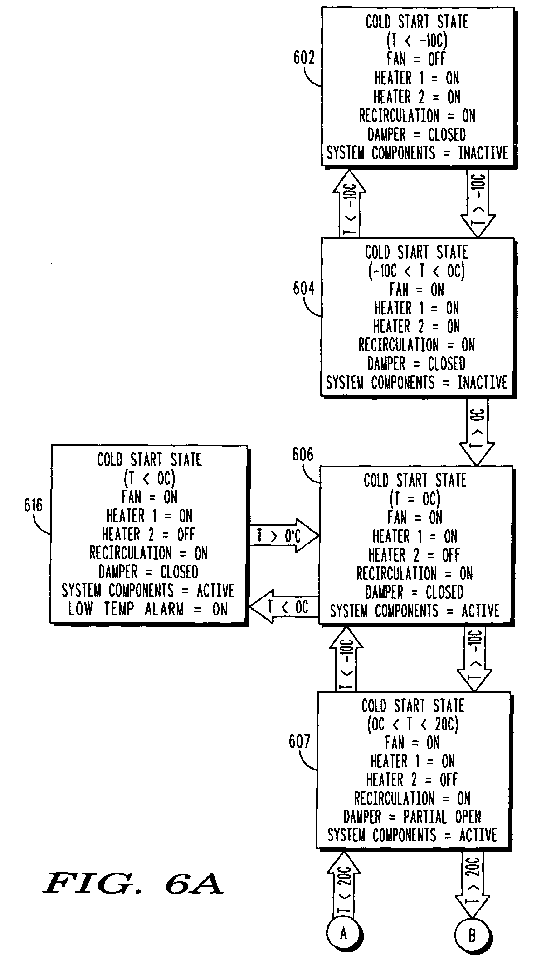

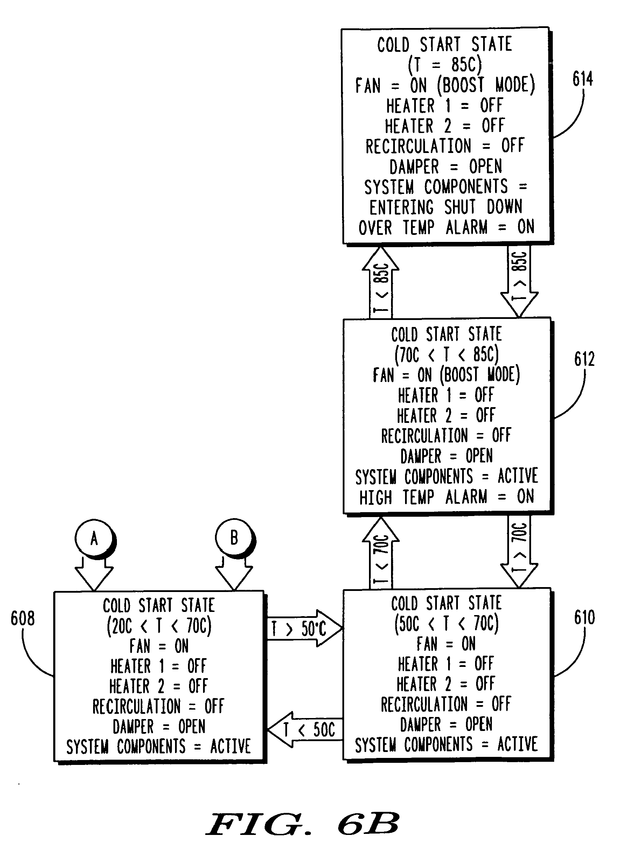

Referring now to FIG. 6, an example of transitioning between states in a system that regulates environmental conditions in an enclosure is described. Similar to the example of FIG. 2, two heaters (a first heater and a second heater) and a fan are used. Additionally, a damper is arranged to exhaust air at the top of the enclosure. Further, a re-circulation valve and conduit are arranged to re-circulate air from the top of the enclosure through the heater.

Initially, at a cold start state 602, the fan is off, the first heater is on, the second heater is on, and the damper is closed. If the temperature remains below - 10 degrees Celsius, the system remains in the state 602. If the temperature within the enclosure rises above -10 degrees Celsius, then the system transitions to state 604.

In the state 604, the fan is on, the first heater is on, the second heater is on, re-circulation is being performed, and the damper is closed. If the temperature goes above 0 degrees Celsius, the system transitions to state 606. If the temperature remains between -10 and 0 degrees Celsius, the system remains in the state 604. If the temperature falls below -10 degrees Celsius the system transitions back to the previous state 602.

In the state 606, the fan is on, the first heater is on, the second heater is off, re-circulation is being performed, the damper is closed and the system components are active. If the temperature goes above 0 degrees Celsius but does not exceed 19 degrees Celsius the damper transitions from a closed to partially open state 607 and exhaust from the enclosure is being performed. If the temperature within the enclosure reaches 20 degrees Celsius, the system transitions to state 608. If the temperature of the enclosure falls below 0 degrees Celsius, then the system transitions to state 616.

In the state 608, the fan is on, the first heater is off, the second heater is off, the system components are active, re-circulation is transitioning from partially open to closed, and the damper is transitioning from partially open to open. If the temperature in the enclosure goes above 50 degrees Celsius then the system transitions to state 610. If the temperature falls below 20 degrees Celsius, then the system returns to state 607.

In the state 610, the fan is on, the first heater is off, the second heater is off, the system components are active, re-circulation has halted and the damper is open. If the temperature within the enclosure is between 50 degrees and an over-temperature threshold of 70 degrees Celsius, the system remains at state 610 and the fan moves from full speed to boost mode as the temperature within the enclosure approaches the over temperature threshold. If the temperature reaches an over-temperature threshold, the system transitions to state 612. If the temperature falls below 50 degrees Celsius the system transitions back to state 608.

In the state 612, the fan is on, the first heater is off, the second heater is off, the system components are active, re-circulation is halted, and the damper is open. The temperature within the enclosure has reached a high temperature threshold and the fan is in "boost" mode. Additionally, an alarm is sent to the user so that the user may be informed of the high-temperature condition. If the temperature within the enclosure reaches an over-temperature threshold of 85 degrees Celsius the system transitions to state 614. If the temperature within the enclosure falls below the high-temperature threshold, the system returns to state 610.

In state 614 the fan is on and in boost mode, the first heater is off, the second heater is off, the system components are active, re-circulation is halted, and the damper is open. An over-temperature alarm is sent and the system begins a shut down sequence to de-energize all functions provided by the backplane so as to disable all heat generating components. If the temperature within the enclosure falls below the high temperature threshold the system returns to state 612.

In state 616, the fan is on, the first heater is on, the second heater is off, re-circulation is being performed, the damper is closed, and the system components are active. Additionally, a low temperature alarm is sent to the user so that the user may be informed of the low temperature condition. If the temperature within the enclosure rises above 0 degrees Celsius, the system transitions to state 606.

It will be appreciated that variations of the state transition sequence are possible and may depend upon (among other things) the objectives (e.g., temperature or pressure levels) that are desired to be obtained within the enclosure. It will also be understood that these objectives may be achieved by operating the components in other states, in other ways, or according to other transition sequences.

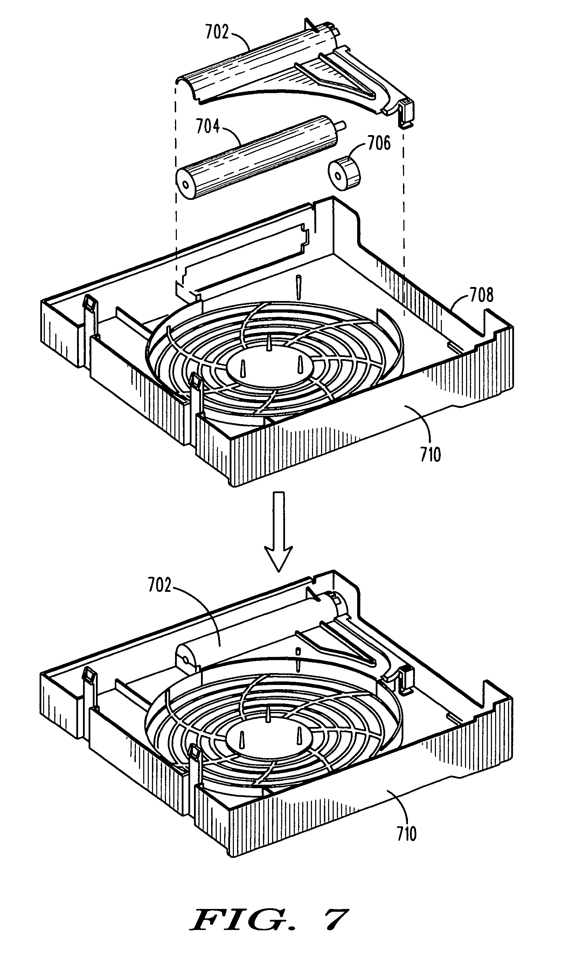

Referring now to FIGs. 7-10, an example of an air circulation module 700 is described. As shown in FIG. 7, an airflow re-circulation valve 701 includes a bi-metallic spring 706 that is coupled to a rotary member 704. A re-circulation plate 702 covers the combination of the rotary member 704 and the bi-metallic spring 706, and the combination is positioned within a first portion 710 of the fan assembly housing. The re-circulation plate 702 may also be part of a feeder arrangement that communicates with the re-circulation valve 701 and directs a flow of air into the airflow re-circulation valve 701. A second portion 711 of the fan housing attaches to the first portion 710 to form the housing of the air circulation module 700. Additionally, a fan 712 is positioned within the air circulation module 700 in order to exhaust air from the air circulation module 700 and/or to re-circulate air. The air circulation module 700 can be used as part of the environmental control system for any of the enclosures that are described elsewhere in this specification.

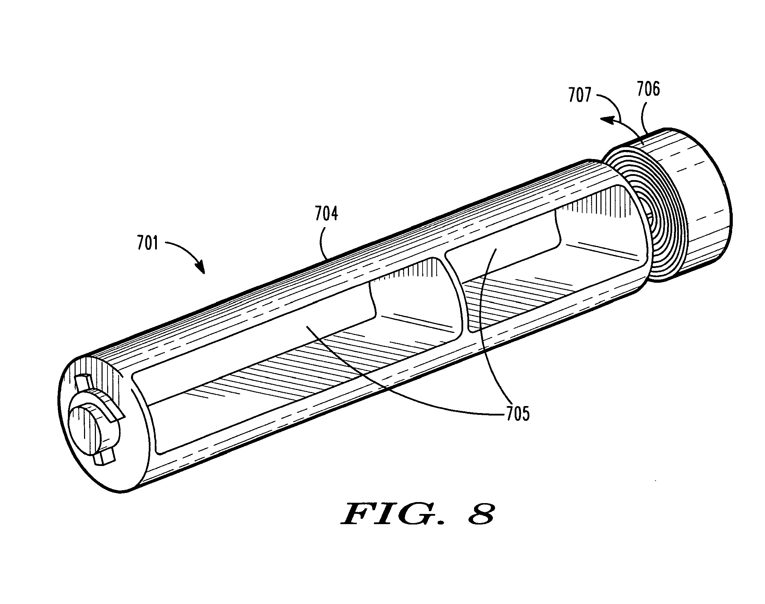

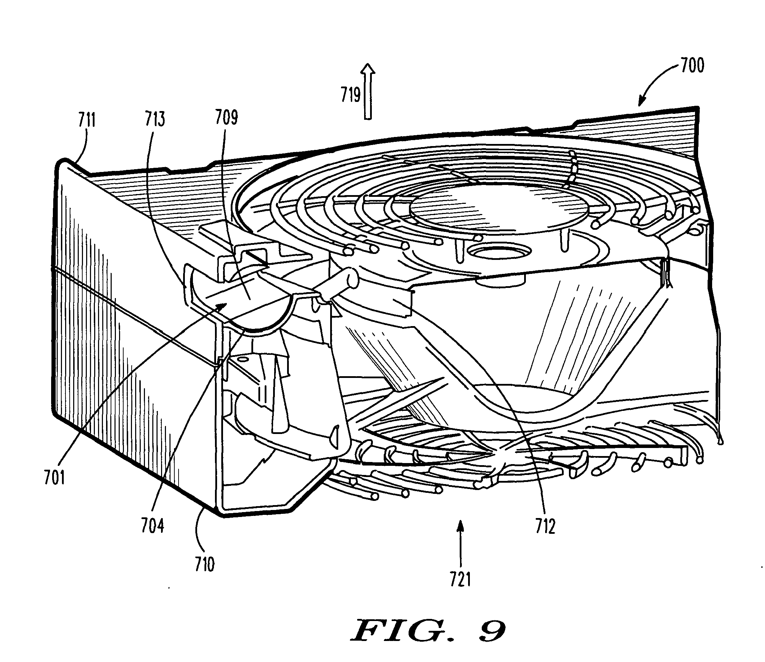

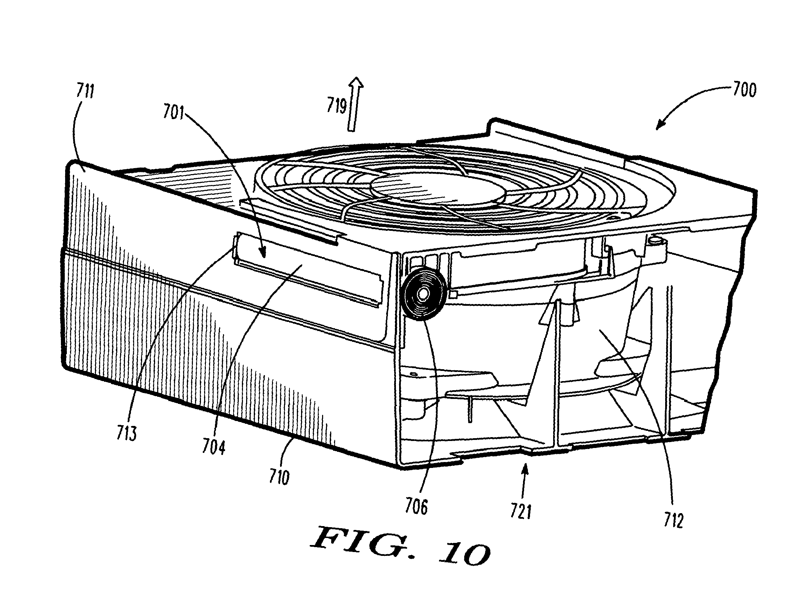

Referring now specifically to FIG. 8, the rotary member 704 is formed with openings 705. As the bi-metallic spring 706 expands and contracts, it causes the rotary member 704 to rotate in the direction of the arrow denoted by reference numeral 707. As can be seen in FIG. 9, the rotary member 704 is responsively rotated to an open or partially open position allowing an airflow 709 to pass though the openings 705 and exhaust out of an exit portal 713 (formed in the air circulation module 701). Alternatively, as shown in FIG. 10, the bi-metallic spring 706 may not contract (or not contract enough) thereby causing the rotary member 704 to remain in a closed position (i.e., so that air can not pass through the openings 705 of the rotary member 704 and out through the exit portal 713 of the air circulation module 700).

The bi-metallic spring 702 may be formed from any suitable metal or material (or combination thereof) that expands and contracts according a predetermined amount for a given temperature thereby allowing the rotary member 704 to rotate. The other elements of the system may be formed from plastic, metal, wood, or some other suitable material. In addition, other types of arrangements not using a bimetallic valve and/or rotary member are possible.

It will be further appreciated that the air circulation module described herein is not limited to use in telecommunication system enclosures. Specifically, the air circulation module as described herein can be used in any type of enclosure to re-circulate air.

In another example of the operation of the system of FIGs. 7-10, an airflow 721 is drawn into the air circulation module 700. The airflow 721 is moved along a direct path about the fan 712 enclosed within the air circulation module 700. The re-circulation valve 701 is automatically and selectively opened so as to not substantially interfere with the direct path of the air flow in order to exhaust a first portion 709 of the air flow 721 from the air circulation module 700. In one example, the amount of opening of the re-circulation valve 701 is determined based upon a temperature in the enclosure. However, the amount of opening may also be determined by other factors (e.g., pressure) as well. A second portion 719 of the airflow 721 may also be exhausted out of the air circulation module 700.

Thus, approaches are provided that allow the environmental conditions of an enclosure to be regulated. The approaches herein are relatively easy and cost effective to implement and facilitate the prevention of the occurrence of environmental conditions within the enclosure that might damage the components housed within the enclosure.

Those skilled in the art will recognize that a wide variety of modifications, alterations, and combinations can be made with respect to the above described embodiments without departing from the spirit and scope of the invention, and that such modifications, alterations, and combinations are to be viewed as being within the scope of the invention.

## Claims

1. A method of controlling a temperature within an electronic component housing comprising:
selectively drawing unheated external air into the electronic component housing;
selectively heating the external air that is drawn into the electronic component housing to form heated air, an extent of the heating based at least in part upon the temperature within the electronic component housing;
drawing a selected one of the heated air and the unheated external air across at least one electronic component positioned within the electronic component housing;
selectively exhausting from the electronic component housing a first flow of the selected one of the heated air and unheated external air that has been drawn across the at least one electronic component, a first amount of the first flow based at least in part upon the temperature within the electronic component housing;
selectively re-circulating within the electronic component housing a second flow of the selected one of the heated air and the unheated external air that has been drawn across the at least one electronic component, a second amount of the second flow based at least in part upon the temperature within the housing; and
wherein the influx, heating, exhausting, and re-circulating operate so as to cause the temperature within the electronic component housing to stay within a predetermined range.

2. The method of claim 1 wherein the heating further comprises heating the second flow of air.

3. The method of claim 1 wherein drawing the external air comprises drawing the external air through a filter.

4. The method of claim 1 wherein drawing the heated air comprises operating a fan so as to draw the heated air across the at least one electronic component at a variable rate based upon the temperature within the housing.

5. The method of claim 1 wherein the exhausting comprises selectively adjusting a position of a damper.

6. The method of claim 1 wherein the re-circulating comprises selectively adjusting a position of a valve.

7. The method of claim 1 further comprising operating the at least one electronic component only when a predetermined temperature has been reached.

8. A system comprising:
a housing;
an entrance portal extending through the housing;
at least one heater positioned within the housing and in communication with the entrance portal, the at least one heater adapted to selectively heat external air flowing through the entrance portal to form heated air based upon a temperature within the housing;
an air flow control device;
at least one electronic component positioned between the at least one heater and the air flow control device;
wherein the air flow control device is adapted to draw the heated air across the at least one electronic component and selectively direct a flow of the air that has been drawn across the at least one electronic component into at least one of a plurality of pathways based upon the temperature within the housing; and
wherein an amount of the flow into each of the plurality of passageways is chosen and the activation of the at least one heater is made so as to cause the temperature within the housing to stay within a predetermined range.

9. The system of claim 8 further comprising a temperature sensor and
wherein the at least one heater receives the temperature within the housing from the temperature sensor.

10. The system of claim 8 wherein the plurality of passageways comprises at least one passageway selected from a group comprising: an exhaust portal that extends through the housing and in communication with the air-flow control device and a re-circulation conduit that is in communication with the at least one heater and the air flow control device.

11. The system of claim 8 further comprising a filter that is positioned across the entrance portal.

12. The system of claim 8 wherein the air flow control device comprises a fan.

13. The system of claim 12 wherein the air flow control device further comprises a damper.

14. The system of claim 8 wherein the air flow control device further comprises a re-circulation valve.

15. The system of claim 8 wherein the at least one heater comprises a first heater and a second heater, wherein the first heater is operational until the temperature reaches a first value and the second heater is operational until the temperature reaches a second value.
